# EUROPÄISCHE PATENTSCHRIFT

(11) **EP 1 601 016 B1**
(45) Veröffentlichungstag und Bekanntmachung des Hinweises auf die Patenterteilung: **25.04.2012**
(21) Anmeldenummer: 05009074.5
(22) Anmeldetag: 26.04.2005
(51) Int. Cl.: H05K 1/14, H01L 23/48, H01L 25/16

(54) **Anordnung in Schraub-Druckkontakierung mit einem Leistungshalbleitermodul**
Apparatus in screw pressure contact with a power semiconductor module
Dispositif en contact à pression par l'intermédiaire de vis avec un module semi-conducteur de puissance

(30) Priorität: 25.05.2004 DE 102004025609
(43) Veröffentlichungstag der Anmeldung: 30.11.2005
(73) Patentinhaber: Semikron Elektronik GmbH & Co. KG Patentabteilung, 90431 Nürnberg (DE)
(72) Erfinder: Steger, Jürgen, 91355 Hilpoltstein (DE)

(56) Entgegenhaltungen:
- EP-A- 0 924 845
- DE-A1- 10 031 678
- DE-C1- 10 231 219
- JP-A- 6 045 721
- US-A- 4 630 174
- US-A1- 2003 106 924

## Beschreibung

### Beschreibung

Die Erfindung beschreibt eine Anordnung in einer Kombination aus einer Schraub- und einer Druckkontaktierung für kompakte Leistungshalbleitermodule. Verschiedene moderne Ausgestaltungen von Leistungshalbleitermodulen mit hoher Leistung bezogen auf ihre Baugröße sind der Ausgangspunkt dieser Erfindung. Hierzu zählen Leistungshalbleitermodule, wie sie aus den Druckschriften EP 0 513 410 A1, DE 196 30 173 C2 oder der DE 199 24 993 C2 bekannte sind.

Die DE 196 30 173 C2 offenbart ein Leistungshalbleitermodul zur direkten Montage auf einer Kühleinrichtung, bestehend aus einem Gehäuse und einem elektrisch isolierenden Substrat, welches seinerseits aus einem Isolierstoffkörper mit einer Mehrzahl darauf befindlicher gegeneinander isolierter metallischer Leiterbahnen und darauf befindlichen und mit diesen Verbindungsbahnen schaltungsgerecht verbundenen Leistungshalbleiterbauelementen besteht. Die externe elektrische Verbindung sowohl der Leistungs- als auch der Hilfsanschlüsse zu den Leiterbahnen einer außerhalb des Gehäuses angeordneten Leiterplatte erfolgt mittels gleichartiger Kontaktfedern.

Das Leistungshalbleitermodul weist weiterhin mindestens eine zentral angeordnete Ausnehmung zur Durchführung einer Schraubverbindung auf. Diese dient zusammen mit einem auf der dem Leistungshalbleitermodul abgewandten Seite der Leiterplatte angeordneten und auf dieser flächig aufliegenden, formstabilen Druckstück der Druckkontaktierung des gesamten Moduls. Diese Druckkontaktierung erfüllt gleichzeitig zwei Aufgaben: einerseits die sichere elektrische Kontaktierung der Anschlusselemente mit der Leiterplatte und andererseits die thermische Kontaktierung des Moduls mit einem Kühlkörper, wobei beide Kontaktierungen reversibel sind.

Nachteilig an diesen Leistungshalbleitermodulen nach dem dargestellten Stand der Technik ist, dass das bekannte Druckstück eine Anordnung von weiteren Bauelementen, wie beispielhaft Widerständen, Kondensatoren oder integrierten Schaltungen, auf dem von ihm überdeckten Teil der Leiterplatte nicht gestattet. Weiterhin nachteilig hierbei ist, dass für höhere Leistungen die Stromtragfähigkeit der Kontaktfedern nicht mehr ausreichend ist.

Aus der US 4,630,174 ist es ebenso bekannt Last- und Hilfsanschlüsse mittels einer externen Leiterplatte vorzusehen. Allerdings weisen hier die Lastanschlüsse bekannte Schraubverbindungen auf, während die Hilfsanschlüsse mittels ebenso bekannter Lötverbindungen ausgebildet sind.

Beispielhaft aus der DE 199 24 993 C2 sind weiterhin Leistungshalbleitermodule bekannt, bei denen die Anschlüsse zwischen Leistungshalbleitermodul und einer Leiterplatte als Lötstifte ausgeführt sind. Diese Lötstifte dienen als Steuer- sowie als Lastanschlusselemente der elektrischen Verbindung der Leistungshalbleiterbauelemente innerhalb des Leistungshalbleitermoduls mit den auf der Leiterplatte angeordneten Zuleitungen. Das Leistungshalbleitermodul kann somit entweder direkt oder, wie in der DE 199 24 993 offenbart, mittels einer Adapterplatine mit einer Leiterplatte verbunden werden.

Nachteilig an der Ausgestaltung derartiger Leistungshalbleitermodule ist, dass Lötanschlüsse der bekannten Art einer einfachen Demontage des Leistungshalbleitermoduls aus einer übergeordneten Anordnung nur erschwert möglich ist. Weiterhin ist bekannt, dass derartige Lötverbindungen nur eine geringe Stromtragfähigkeit aufweisen. Ein besonderer Nachteil besteht hierbei darin, dass die Kontaktsicherheit der Lötverbindungen über die Lebensdauer nicht gegeben ist.

Weiterhin sind aus einer Vielzahl von Druckschriften beispielhaft der EP 0 513 410 A1, Leistungshalbleitermodule bekannt, wobei die Leistungsanschlüsse als separate Schraubanschlüsse und die Hilfsanschlüsse als Steckkontakte ausgebildet sind. Nachteilig an dieser Ausgestaltung ist der nötige Montageaufwand für die einzelnen Anschlüsse.

Aus der JP 6-045721 A ist ein Leistungshalbleitermodul bekannt, bei dem alternativ zu den oben genannten Steckkontakten der Hilfsanschlüsse ein Verbindungsmittel mit einem Isolierstoffkörper und jeweils zwei Kontaktstiften benutzt wird. Einer diese Kontaktstifte kontaktiert das Substrat während der andere eine externe Leiterplatte kontaktiert. Innerhalb des Isolierstoffkörpers bilden die Kontaktstifte eine Steckverbindung aus. Der vorliegenden Erfindung liegt die Aufgabe zu Grunde eine Anordnung mit einer Leiterplatte und einem Leistungshalbleitermodul vorzustellen, mit ausreichender Stromtragfähigkeit der Leistungsanschlüsse und gleichzeitiger einfacher und effektiver Druckkontaktierung der Hilfsanschlüsse.

Diese Aufgabe wird gelöst durch eine Anordnung nach dem Anspruch 1, spezielle Ausgestaltungen finden sich in den Unteransprüchen. Der Grundgedanke der Erfindung geht aus von einem Leistungshalbleitermodul mit einem rahmenartigen isolierenden Gehäuse und einem einstückig damit verbundenen Deckel. Weiterhin ist es vorteilhaft wenn das Leistungshalbleitermodul eine metallische Grundplatte aufweist. Über das Gehäuse und / oder die Grundplatte kann das Leistungshalbleitermodul auf einer Kühleinrichtung angeordnet werden. In seinem Inneren weist das Leistungshalbleitermodul mindestens ein Substrat auf. Dieses Substrat besteht aus einem Isolierstoffkörper, beispielhaft bestehend aus einer Industriekeramik wie Aluminumoxid oder Alumniumnitrit. Auf diesem Isolierstoffkörper ist mindestens auf der dem Inneren des Leistungshalbleitermoduls zugewandten Hauptfläche eine metallische Kaschierung angeordnet. Diese Kaschierung ist vorteilhafterweise in sich strukturiert und bildet somit voneinander isolierte Leiterbahnen. Auf diesen Leiterbahnen ist mindestens ein Leistungshalbleiterbauelement angeordnet und mit weiteren Leiterbahnen und / oder weiteren Leistungshalbleiterbauelementen schaltungsgerecht verbunden.

Das Leistungshalbleitermodul weist zu seinem externen Anschluss Leistungsanschlüsse, als Plus-, Minus- und Wechselstromanschlüsse, und Hilfsanschlüsse, als Gate-, Hilfsemitter- und / oder Sensoranschlüsse auf. Erfindungsgemäß sind die Leistungsanschlüsse als Schraubanschlüsse und die Hilfsanschlüsse als druckkontaktierte Anschlüsse ausgebildet. Bei den Hilfsanschlüssen verbindet jeweils mindestens eine Kontaktfeder die jeweilige Leiterbahn des Substrats mit der dieser zugeordneten Leiterbahn der Leiterplatte.

Die Leiterplatte ist hierbei auf der der Kühleinrichtung abgewandten Seite des Leistungshalbleitermoduls angeordnet. Erfindungsgemäß überdeckt die Leiterplatte die Hilfsanschlüsse und vorzugsweise auch die Leistungsanschlüsse des Leistungshalbleitermoduls. Dies ergibt nach dem oben Dargestellten eine Anordnung in Schraub- Druckkontaktierung.

Vorzugsweise weist die Leiterplatte Ausnehmungen im Bereich der Schraubanschlüsse und / oder für weitere Schraubverbindungen auf. Durch die Ausnehmungen der Leiterplatte hindurch reichen die Schrauben der Schraubkontaktierung der Leistungsanschlüsse und Beaufschlagen somit die Leiterplatte mit Druck. Hierdurch wird Druck auf die Kontaktfedern der Hilfsanschlüsse eingeleitet und diese werden elektrisch sicher kontaktiert.

Vorteilhaft an der erfindungsgemäßen Ausgestaltung der oben genannten Anordnung ist somit, dass sie einerseits die bekannten Vorteile der Druckkontaktierung der Hilfsanschlüsse mit der Zuverlässigkeit und Flexibilität der Schraubverbindung der Lastanschlüsse in einer kompakten Ausgestaltung verbindet.

Die Erfindung wird anhand von Ausführungsbeispielen in Verbindung mit den Fig. 1 bis 4 näher erläutert.

Fig. 1 zeigt eine Ausgestaltung eines Leistungshalbleitermoduls einer erfindungsgemäßen Anordnung in Draufsicht.

Fig. 2 zeigt die erfindungsgemäße Anordnung nach Fig. 1 einer Leiterplatte und eines Leistungshalbleitermoduls in der Seitenansicht.

Fig. 3 zeigt in dreidimensionaler Explosionsdarstellung eine weitere erfindungsgemäße Anordnung.

Fig. 4 zeigt eine weitere Darstellung einer erfindungsgemäßen Anordnung nach Fig. 3.

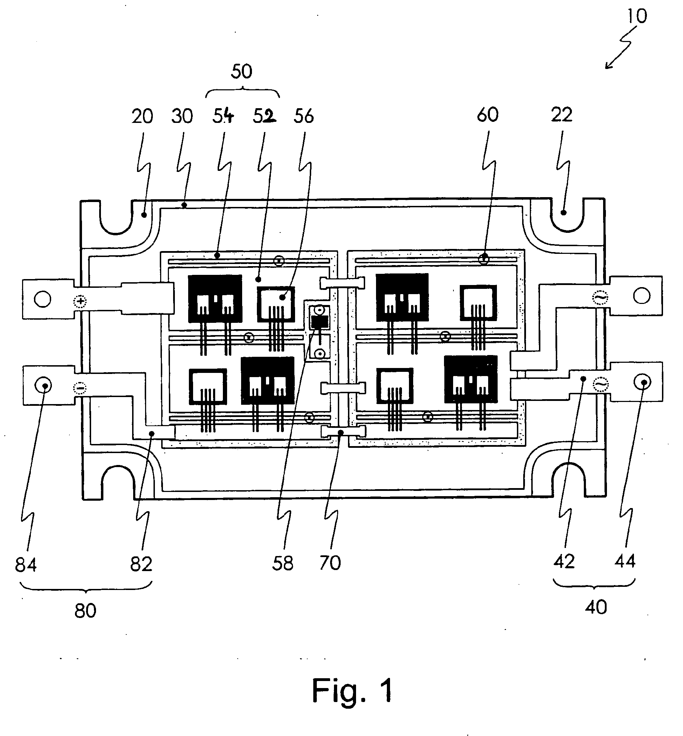

Fig. 1 zeigt eine Ausgestaltung eines Leistungshalbleitermodul (10) einer erfindungsgemäßen Anordnung in Draufsicht. Dieses Leistungshalbleitermodul (10) besteht aus einer metallischen Grundplatte (20) mit Ausnehmungen (22) zur Schraubverbindung mit einer nicht dargestellten Kühleinrichtung. Auf dieser Grundplatte (20) ist das rahmenartige Gehäuse (30) angeordnet. Dieses umschließt zwei Substrate (50). Diese sind ebenfalls auf der Grundplatte (20) angeordnet und mittels einer Lötverbindung mit dieser verbunden.

Das jeweilige Substrat (50) besteht aus einem Isolierstoffkörper (54), vorzugsweise hergestellt aus einer Industriekeramik wie Aluminiumoxid oder Aluminiumnitrit. Hierauf angeordnet ist eine metallische Kaschierung, vorzugsweise aus Kupfer oder einer Kupferlegierung, die in sich strukturiert ist und somit einzelne voneinander isolierte Leiterbahnen (52) bildet. Auf diesen Leiterbahnen sind Leistungshalbleiterbauelemente (56) angeordnet und mit weiteren Leiterbahnen (52) schaltungsgerecht verbunden. Die dargestellte Schaltungsanordnung ist eine zum Stand der Technik zu zählende Halbbrückenschaltung. Zur schaltungsgerechten Verbindung der beiden Substrate sind hier Lötbrücken (70) dargestellt. Auf dem linken Substrat befindet sich weiterhin ein Temperatursensor (58).

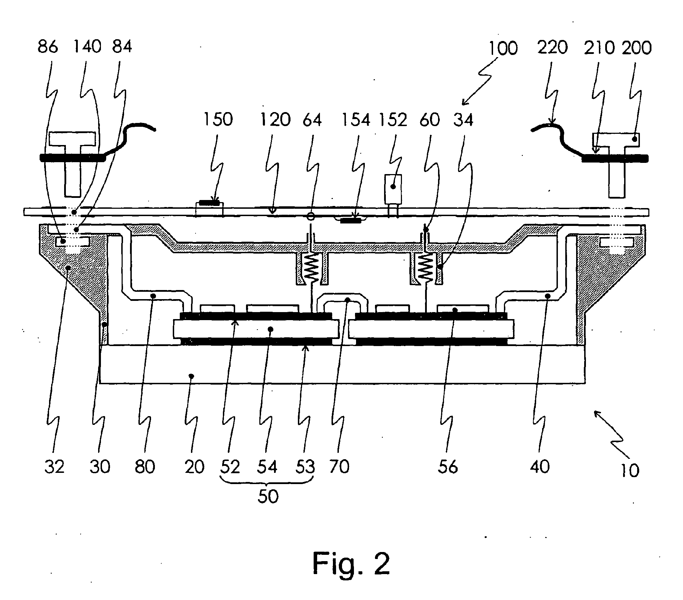

Zur externen elektrischen Verbindung weist das Leistungshalbleitermodul Leistungs-(40, 80) und Hilfsanschlüsse (60) auf. Zur Verbindung zu einem Gleichstromzwischenkreis weist das Leistungshalbleitermodul die Gleichstromanschlüsse (80) auf. Diese sind als Metallschienen ausgebildet und löttechnisch mit den zugeordneten Leiterbahnen (52) des Substrats (50) verbunden. Weiterhin weisen die Gleichstromanschlüsse Ausnehmungen (84) auf. Diese Ausnehmungen dienen der Schraubverbindung, siehe Fig. 2. In ebensolcher Weise ist der doppelt ausgeführte Wechselstromanschluss (40) ausgebildet.

Die Hilfsanschlüsse (60) sind als Kontaktfedern, hier speziell Tonnenfedern, ausgebildet. Dargestellt ist weiterhin der Kontaktpunkt der Kontaktfeder (60) mit der jeweiligen Leiterbahn (52) des Substrats (50).

Fig. 2 zeigt die erfindungsgemäße Anordnung einer Leiterplatte und eines Leistungshalbleitermoduls nach Fig. 1 in der Seitenansicht, wobei die Leiterplatte (100) und das Leistungshalbleitermodul (10) geringfügig beabstandet zueinander dargestellt sind um die Schraub- Druckkontaktierung darstellen zu können. Dargestellt ist die Grundplatte (20) des Leistungshalbleitermoduls (10). Hierauf angeordnet sind das rahmenartige Gehäuse (30) sowie die beiden Substrate (50). Jedes Substrat (50) besteht wie unter Fig. 1 beschrieben aus einem Isolierstoffkörper (54) sowie aus metallischen Kaschierungen, die auf beiden Hauptflächen angeordnet sind. Die der Grundplatte (20) zugewandte metallische Kaschierung (53) ist flächig ausgebildet und nicht strukturiert. Demgegenüber ist dem Leistungshalbleitermodulinneren zugewandte Kaschierung in sich strukturiert und bildet somit die Leiterbahnen (52) des Substrats aus.

Auf diesen Leiterbahnen (52) sind analog zu Fig. 1 die Leistungshalbleiterbauelemente angeordnet. Die elektrischen Anschlüsse werden gebildet durch die Leistungsanschlüsse (40, 80) und die Hilfsanschlüsse (60). Die druckkontaktierten Hilfsanschlüsse (60) sind als Kontaktfedern ausgebildet und bedürfen einer Druckbeaufschlagung zur sicheren elektrischen Kontaktierung zwischen den Leiterbahnen (52) des Substrats (50) und den zugeordneten Leiterbahnen (120) der Leiterplatte (100).

Die Leistungsanschlüsse werden gebildet durch Metallschienen, die an ihrem einen Ende löttechnisch mit der zugeordneten Leiterbahn (52) des Substrats verbunden sind und an ihrem anderen Ende eine Ausnehmung zu Schraubverbindung aufweisen.

Das einstückig einen Rahmen und einen Deckel bildende Gehäuse (30) weist Ausformungen auf zur Positionierung und Fixierung der Leistungs- (40, 80) und Hilfsanschlüsse (60). Hierzu weist der Deckel mit Ausnehmungen kombinierte Ausformungen (34) auf, die zur Halterung und Durchführung der Kontaktfedern dienen. Die Leistungsanschlüsse werden ebenfalls in einer Ausformung (32) des Gehäuses fixiert. Weiterhin ist in dieser Ausformung (32) unterhalb des jeweiligen Leistungsanschlusses eine Mutter angeordnet und fixiert.

Die Leiterplatte (100) weist auf ihrer dem Leistungshalbleitermodul zugewandten Seite Leiterbahnen (120) auf. Diese bilden die Kontaktpunkte (64) der Kontaktfedern und dienen somit der Verbindung zu den Leiterbahnen (52) des Substrats (50). Weitere Leiterbahnen (120) der Leiterplatte dienen als Verbindung dort angeordneter weiterer elektrischer und elektronischer Bauelemente (150, 152, 154).

Die Druckbeaufschlagung der Leiterplatte (100) zur sicheren elektrischen Kontaktierung der Hilfsanschlüsse (60) erfolgt durch die Schraubverbindung der Lastanschlüsse (40, 80). Hierzu wird jeweils eine Öse eines Plus-, Minus oder Wechselstromanschlusskabels (210) mittels einer Schraube, die durch die Ausnehmungen (140, 180) der Leiterplatte (100) hindurchreicht, mit der zugeordneten Mutter (46, 86) verbunden. Dies bewirkt einerseits die Druckeinleitung auf die Kontaktfedern der Hilfsanschlüsse (60) sowie die sichere elektrische Kontaktierung der Lastanschlüsse (40, 80)

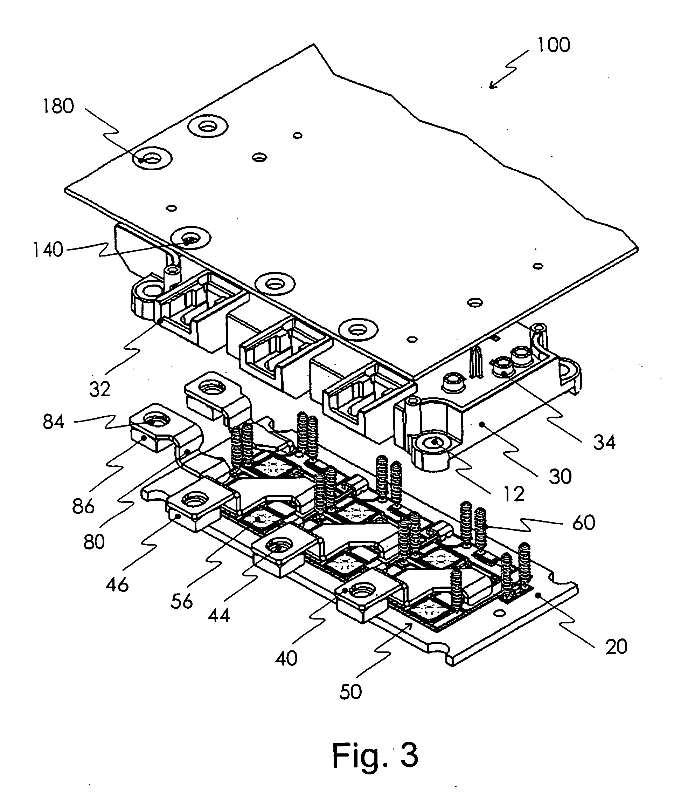

Die weiteren Anschlussverbindungen der Leistungsanschlüsse (40, 80) zur Anbindung an den Gleichstromzwischenkreis und die Last sind hier als Kabelverbindungen (220) ausgebildet. Hierbei wird der elektrische Kontakt der Kabelverbindung zum jeweiligen Anschluss (40, 80) des Leistungshalbleitermoduls (10) über ein Anschlusselement (210), durch welches die Schraubverbindung (200) hindurchreicht, gebildet. Diese Schraubverbindung reicht weiterhin durch die Ausnehmungen (140, 84) der Leiterplatte (100) und des Leistungsanschlusses (80, 40) zur Mutter (46 (siehe Fig. 3), 86).

Fig. 3 zeigt in dreidimensionaler Explosionsdarstellung eine weitere erfindungsgemäße Anordnung. Dargestellt ist die Leiterplatte (100) sowie Kontaktflächen (140, 180) für Anschlussverbindungen (Fig. 2: 210, 220).

Das Leistungshalbleitermodul (10) ist als Drei- Phasen- Brückenschaltung ausgebildet und besteht aus einer Grundplatte (20) und einem Gehäuse (30). Auf der Grundplatte (20) sind drei Substrate (50) und hierauf die Leistungshalbleiterbauelemente (56) angeordnet. Die Gleichspannungsanschlüsse (80) sind an der Stirnseite des Leistungshalbleitermoduls (10) angeordnet, wobei die zugeordneten Leiterbahnen mittels Lötbrücken, vgl. Fig. 2 (70), miteinander verbunden sind. Die Wechselstromanschlüsse sind an der Breitseite des Leistungshalbleitermoduls (10) angeordnet und weisen jeweils einen Wechselstromanschluss (40) auf. Sämtliche Leistungsanschlüsse (40, 80) weisen Ausnehmungen (44, 84) auf. Die Leistungsanschlüsse sind samt den darunter angeordneten Muttern (46, 86) zur Schraubkontaktierung in entsprechenden Ausnehmungen (32) des Gehäuses (30) angeordnet.

Dargestellt sind ebenfalls die bereits beschriebenen und als Kontaktfedern (60) ausgebildeten Hilfsanschlüsse. Diese sind in Ausformungen (34) des Gehäuses fixiert. Die Ausformungen weisen Ausnehmungen zur Durchführung von Teilen der Kontaktfedern (60) auf um den elektrischen Kontakt zu Leiterbahnen der Leiterplatte (100) herzustellen. Die sichere Kontaktierung erfolgt durch Druckbeaufschlagung auf die Leiterplatte (100). Hierzu werden die Schraubanschlüsse der Leistungsanschlüsse (40, 80) festgezogen und somit sowohl die Leistungsanschlüsse (40, 80) als auch die Hilfsanschlüsse (60) dauerhaft sicher elektrisch kontaktiert.

Weiterhin weist das Gehäuse Ausnehmungen (12) auf zur Schraubverbindung mit einem nicht dargestellten Kühlkörper.

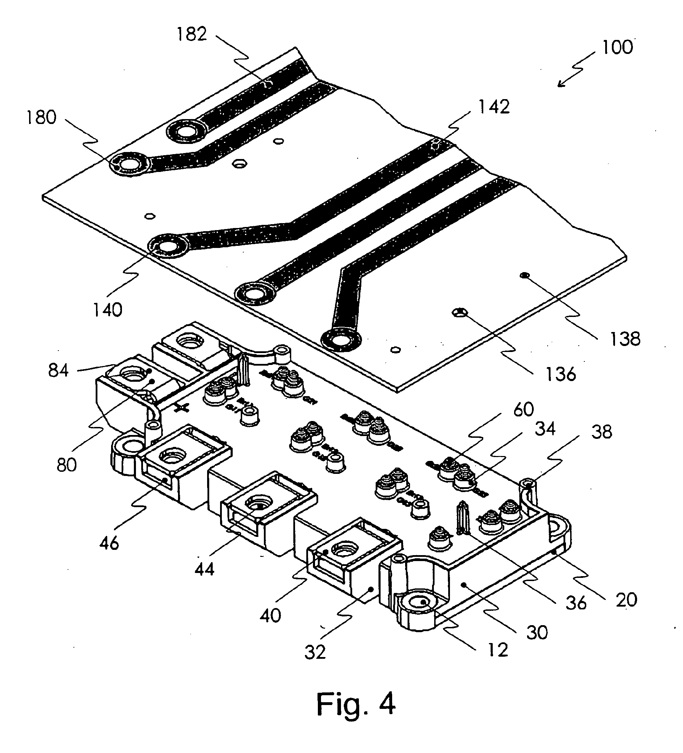

Fig. 4 zeigt eine weitere Darstellung einer erfindungsgemäßen Anordnung ähnlich Fig. 3. Hierbei sind allerdings die Anschlussverbindungen der Leistungsanschlüsse (40, 80) zum Anschluss an den Gleichstromzwischenkreis und die Last als Leiterbahnen (142, 182) der Leiterplatte (100) ausgebildet. Dies ist besonders für die Gleichstromanschlüsse (180) vorteilhaft, da hierbei eine niederinduktive Anbindung des Zwischenkreises besonders leicht zugänglich ist. In gleicher Weise sind, wie auch in Fig. 2 dargestellt, die Anschlussverbindungen der Hilfsanschlüsse (60) als Leiterbahnen auf der Unterseite der Leiterplatte (100) ausgebildet.

Die weiteren Elemente sind identisch mit denjenigen der Fig. 3. Weiterhin weist die Leiterplatte (100) Ausnehmungen (136) auf um dornartige Fortsätze (36) des Gehäuses (30) des Leistungshalbleitermoduls (10) aufzunehmen. Diese dornartigen Fortsätze dienen der Justage der Leiterplatte (100) zum Leistungshalbleitermodul (10).

Die Ausnehmungen (138) der Leiterplatte sowie die mit Ausnehmungen versehenen Fortsätze (38) des Gehäuses (30) dienen der weiteren Schraubverbindung der Leiterplatte (100) mit dem Gehäuse (30) des Leistungshalbleitermoduls (10).

## Patentansprüche

1. Anordnung in Schraub- Druckkontaktierung mit einer Leiterplatte (100) und einem Leistungshalbleitermodul (10), wobei die Leiterplatte (10) ein isolierendes Substrat mit darauf angeordneten Leiterbahnen (120) aufweist, und das Leistungshalbleitermodul (10) ein einstückig einen Rahmen und einen Deckel bildendes isolierendes Kunststoffgehäuse (30), mindestens ein hierin angeordnetes Substrat (50) mit mindestens einer Leiterbahn (52) und mindestens einem hierauf angeordneten und schaltungsgerecht verbundenen Leistungshalbleiterbauelement (56) sowie Leistungsanschlüsse (40, 80), wie Plus-, Minus- und Wechselstromanschlüsse, und Hilfsanschlüsse (60), wie Gate-, Hilfsemitter- und / oder Sensoranschlüsse aufweist,
und wobei die Leistungsanschlüsse (40, 80) als Schraubanschlüsse ausgebildet sind, und die Hilfsanschlüsse (60) druckkontaktiert mit jeweils mindestens einer die jeweilige Leiterbahn (52) des Substrats (50) mit der zugeordneten Leiterbahn (120) der Leiterplatte (100) verbindenden Kontaktfeder (60) ausgebildet sind und die Schrauben der Schraubkontaktierung der Leistungsanschlüsse (40, 80) durch Ausnehmungen (140, 180, 138) der Leiterplatte (100) hindurchreichen und somit die Druckeinleitung für die Hilfsanschlüsse (60) bilden und wobei die Kontaktfedern (60) die als Tonnenfeder ausgebildet sind zur Verbindung der jeweiligen Leiterbahnen (52) des Substrats (50) mit den zugeordneten Leiterbahnen (120) der Leiterplatte (100) durch mit Ausnehmungen kombinierte Ausformungen des Gehäusedeckels (30), die gleichzeitig die Führungen und Halterungen der Kontaktfedern (60) bilden, hindurchreichen und wobei weitere Leiterbahnen (120) der Leiterplatte als Verbindung dort angeordneter weiterer elektrischer und elektronischer Bauelemente (150, 152, 154) dienen.

2. Anordnung nach Anspruch 1,
wobei das mindestens eine Substrat (50) auf einer metallischen Grundplatte (20) des Leistungshalbleitermoduls (10) angeordnet ist.

3. Anordnung nach Anspruch 1,
wobei das Gehäuse (30) mindestens einen dornartigen Fortsatz (36) aufweist, der durch eine zugeordnete Ausnehmung (136) der Leiterplatte (100) hindurchreicht.

4. Anordnung nach Anspruch 1,
wobei die Anschlussverbindungen der Leistungsanschlüsse (40, 80) als Kabelverbindungen (210, 220) ausgebildet sind.

5. Anordnung nach Anspruch 1,
wobei die Anschlussverbindungen der Leistungsanschlüsse (40, 80) ebenso wie diejenigen der Hilfsanschlüsse (60) als Leiterbahnen (140, 180, 120) der Leiterplatte (100) ausgebildet sind.

6. Anordnung nach Anspruch 1,
wobei das Substrat (50) aus einem Isolierstoffkörper (54), bestehend aus einer Industriekeramik wie Aluminiumoxid oder Aluminiumnitrit, mit metallischen Kaschierungen auf dessen Hauptflächen besteht und die dem Leistungshalbleitermodulinneren und mit Leistungshalbleiterbauelementen (56) bestückte Kaschierung in sich strukturiert ist und somit voneinander isolierte Leiterbahnen (52) bildet.

## Claims

1. An arrangement in a screw-pressure form of contact with a circuit board (100), a power semiconductor module (10), wherein
the circuit board (10) has an insulating substrate with conducting tracks (120) arranged thereon, and the power semiconductor module (10) has an insulating plastic housing, forming an integral frame and cover, at least one substrate (50) arranged herein, with at least one conducting track (52) and at least one power semiconductor component (56) arranged hereon and connected in accordance with circuit requirements, and also power terminals (40, 80), such as plus, minus and AC terminals, and ancillary terminals (60), such as gate, ancillary emitter, and/or sensor terminals, and wherein
the power terminals (40, 80) are designed as screw terminals, and the ancillary terminals (60) are of pressure-contact design, in each case with at least one contact spring connecting the respective conducting track (52) of the substrate (50) with the associated conducting track (120) of the circuit board (100), and the screws of the screw form of contact of the ancillary terminals (40, 80) extend through recesses (140, 180, 138) of the circuit board (100) and thus form the introduction of pressure onto the ancillary terminals (60), and wherein
the contact springs (60), which are designed as barrel springs for the purpose of connecting the respective conducting tracks (52) of the substrate (50) with the associated conducting tracks (120) of the circuit board (100), extend through mouldings, combined with recesses, of the housing cover (30), which at the same time form the guides and mountings of the contact springs (60), and wherein
further conducting tracks (120) of the circuit board serve to provide connections to further electrical and electronic components (150, 152, 154) there arranged.

2. The arrangement in accordance with Claim 1, wherein
the at least one substrate (50) is arranged on a metallic baseplate (20) of the power semiconductor module (10).

3. The arrangement in accordance with Claim 1, wherein
the housing (30) has at least one pin-type projection (36), which extends through an associated recess (136) of the circuit board (100).

4. The arrangement in accordance with Claim 1, wherein
the terminal connections of the power terminals (40, 80) are designed as cable connections (210, 220).

5. The arrangement in accordance with Claim 1, wherein
the terminal connections of the power terminals (40, 80), as for those of the ancillary terminals (60), are designed as conducting tracks (140, 180, 120) of the circuit board (100).

6. The arrangement in accordance with Claim 1, wherein
the substrate (50) consists of a body of insulating material (54), consisting of an industrial ceramic such as aluminium oxide or aluminium nitrite, with metallic laminations on its main surfaces, and the lamination facing towards the interior of the power semiconductor module and fitted with power semiconductor components (56) is itself structured and thus forms conducting tracks (52) that are insulated from one another.

## Revendications

1. Agencement dans une mise en contact de pression par vissage avec une plaque à circuits imprimés (100) et un module à semi-conducteurs de puissance (10), la plaque à circuits imprimés (10) présentant un substrat isolant avec des pistes conductrices (120) disposées dessus, et le module à semi-conducteurs de puissance (10) présentant un boîtier plastique (30) isolant, formant d'un seul tenant un cadre et un couvercle, au moins un substrat (50) disposé à l'intérieur avec au moins une piste conductrice (52) et au moins un composant à semi-conducteurs de puissance (56) disposé dessus et relié de façon conforme au circuit ainsi que des branchements de puissance (40, 80), tels que des branchements plus, moins et de courant alternatif, et des branchements auxiliaires (60), tels que des branchements de porte, des branchements d'émetteur auxiliaire et/ou des branchements de capteur,
et les branchements de puissance (40, 80) étant conçus sous forme de branchements à vis,
et les branchements auxiliaires (60) étant conçus avec une mise en contact de pression avec respectivement au moins un ressort de contact (60) reliant la piste conductrice (52) respective du substrat (50) à la piste conductrice (120) associée de la plaque à circuits imprimés (100) et les vis de la mise en contact par vissage des branchements de puissance (40, 80) passant à travers des évidements (140, 180, 138) de la plaque à circuits imprimés (100) et formant ainsi l'application de pression pour les branchements auxiliaires (60) et les ressorts de contact (60), qui sont conçus sous forme de ressorts bombés, passant à travers des parties formées, combinées avec des évidements, du couvercle de boîtier, lesquelles parties forment en même temps les guides et les fixations des ressorts de contact (60), pour la liaison des pistes conductrices (52) respectives du substrat (50) avec les pistes conductrices (120) associées de la plaque à circuits imprimés (100), et d'autres pistes conductrices (120) de la plaque à circuits imprimés servant de liaison d'autres composants (150, 152, 154) électriques et électroniques disposés à cet endroit.

2. Agencement selon la revendication 1,
le au moins un substrat (50) étant disposé sur une plaque de base (20) métallique du module à semi-conducteurs de puissance (10).

3. Agencement selon la revendication 1,
le boîtier (30) présentant au moins un appendice (36) en forme de mandrin, qui passe à travers un évidement (136) associé de la plaque à circuits imprimés (100).

4. Agencement selon la revendication 1,
les liaisons de branchement des branchements de puissance (40, 80) étant conçues sous forme de liaisons de câble (210, 220).

5. Agencement selon la revendication 1,
les liaisons de branchement des branchements de puissance (40, 80) étant conçues de même que celles des branchements auxiliaires (60) comme pistes conductrices (140, 180, 120) de la plaque à circuits imprimés (100).

6. Agencement selon la revendication 1,
le substrat (50) étant fait à partir d'un corps en matière isolante (54), à base d'une céramique industrielle telle que de l'oxyde d'aluminium ou du nitrite d'aluminium, avec des placages métalliques sur ses surfaces principales et le placage appliqué à l'intérieur du module à semi-conducteurs de puissance et équipé de composants à semi-conducteurs de puissance (56), étant structuré en soi et formant ainsi des pistes conductrices (52) isolées les unes des autres.
